(19) Europäisches Patentamt / European Patent Office / Office européen des brevets

(11) **EP 2 342 539 B1**

(12) **EUROPÄISCHE PATENTSCHRIFT**

(45) Veröffentlichungstag und Bekanntmachung des Hinweises auf die Patenterteilung:
**06.09.2017 Patentblatt 2017/36**

(51) Int Cl.:
*G01D 5/245* *(2006.01)*      *G01D 5/249* *(2006.01)*
*G01D 5/347* *(2006.01)*      *H03M 1/28* *(2006.01)*

(21) Anmeldenummer: **09778775.8**

(22) Anmeldetag: **30.09.2009**

(86) Internationale Anmeldenummer:
**PCT/EP2009/007014**

(87) Internationale Veröffentlichungsnummer:
**WO 2010/049046 (06.05.2010 Gazette 2010/18)**

(54) **ABSOLUTE POSITIONSMESSVORRICHTUNG**

ABSOLUTE POSITION MEASURING DEVICE

DISPOSITIF DE MESURE DE POSITION ABSOLUE

(84) Benannte Vertragsstaaten:
**AT BE BG CH CY CZ DE DK EE ES FI FR GB GR HR HU IE IS IT LI LT LU LV MC MK MT NL NO PL PT RO SE SI SK SM TR**

(30) Priorität: **30.10.2008 DE 102008053977**

(43) Veröffentlichungstag der Anmeldung:
**13.07.2011 Patentblatt 2011/28**

(73) Patentinhaber: **Dr. Johannes Heidenhain GmbH 83301 Traunreut (DE)**

(72) Erfinder:
- **MAYER, Elmar 83365 Nussdorf (DE)**
- **BENNER, Ulrich 83308 Trostberg (DE)**
- **LINGK, Christoph 83278 Traunstein (DE)**
- **SCHÜRMANN, Thomas 83026 Rosenheim (DE)**

(56) Entgegenhaltungen:
**EP-B1- 0 800 725      WO-A1-2008/056546 US-A- 5 135 081**

**Beschreibung**

Die Erfindung betrifft eine absolute Positionscodierung einer Positionsmessvorrichtung gemäß dem Patentanspruch 1.

Weiterhin betrifft die Erfindung eine absolute Positionsmessvorrichtung gemäß dem Patentanspruch 6.

Auf vielen Gebieten werden zur Bestimmung der Position zweier relativ zueinander bewegter Körper vermehrt absolute Positionsmessvorrichtungen eingesetzt. Absolute Positionsmessvorrichtungen haben gegenüber rein inkremental messenden Systemen den Vorteil, dass in jeder Relativlage auch nach Unterbrechung der Versorgungsenergie sofort eine korrekte Positionsinformation ausgegeben werden kann.

Die absolute Position wird dabei von einer Positionscodierung verkörpert. Besonders Platz sparend ist die Anordnung der Positionscodierung bzw. Positionsinformation in einer einzigen Codespur mit in Messrichtung hintereinander angeordneten Codeelementen. Die Codeelemente sind dabei in pseudozufälliger Verteilung hintereinander angeordnet, so dass eine bestimmte Anzahl von aufeinander folgenden Codeelementen jeweils ein Codewort bildet, das die absolute Position eindeutig definiert. Bei der Verschiebung der Abtasteinrichtung um ein einziges Codeelement wird bereits ein neues Codewort gebildet und über den gesamten absolut zu erfassenden Messbereich steht eine Folge von unterschiedlichen Codewörtern zur Verfügung. Ein derartiger serieller bzw. sequentieller Code wird auch oft als Kettencode oder als Pseudo-Random-Code bezeichnet.

Zur Bestimmung der absoluten Position aus den abgetasteten Codewörtern - auch Decodierung genannt - wird eine Decodiertabelle eingesetzt, in der jedem Codewort eine Position zugeordnet ist. Zur Zuordnung der absoluten Position zu einem abgetasteten Codewort bildet das Codewort die Adresse für die Decodiertabelle, so dass am Ausgang die für dieses Codewort abgelegte absolute Position ansteht und zur Weiterverarbeitung zur Verfügung steht. Diese nichtflüchtigen Tabellen können heute in einem ASIC hardwareverdrahtet ausgelegt sein, um einen schnellen Zugriff zu ermöglichen.

Die Anforderungen an die Auflösung von Positionsmessvorrichtungen werden immer höher, so dass innerhalb eines vorgegebenen Messbereiches viele Positionen eindeutig zu codieren sind. Weiterhin werden bei Längenmessvorrichtungen die absolut zu bestimmenden Längen immer größer. Je mehr Positionen aber codiert werden müssen, umso aufwendiger ist die nachfolgende Decodierung und der Speicherbedarf. Problematisch bei einer seriellen Positionscodierung ist, dass für eine hohe Auflösung und eine große Messlänge sehr viele verschiedene Codewörter generiert und decodiert werden müssen. Erfolgt die Decodierung mittels Tabellen, ist eine große Tabelle erforderlich, in der für jedes mögliche Codewort eine dazugehörige absolute Position abgelegt ist. Erfolgt die Decodierung mittels eines Rechners, führt dies zu relativ langen Rechenzeiten.

Die WO 2008/056546 A1 zeigt eine Maßnahme auf, wie eine Positionscodierung und eine Längenmessvorrichtung ausgestaltet werden kann, um große Messbereiche codieren zu können und um den Aufwand der Decodierung zu verringern. Hierzu sind zwei parallel zueinander angeordnete Codespuren vorgesehen. In der ersten Codespur ist eine erste Codesequenz mehrfach in Messrichtung hintereinander angeordnet. In der zweiten Spur ist diese gleiche Codesequenz ebenfalls mehrfach in Messrichtung hintereinander angeordnet. Die Breite der Codeelemente der ersten Spur unterscheidet sich von der Breite der Codeelemente der zweiten Spur geringfügig, so dass sich die Ausdehnung in Messrichtung der Codesequenz in der ersten Spur von der Ausdehnung der Codesequenz in der zweiten Spur geringfügig unterscheidet. Dieser sich über den Messbereich verändernde Unterschied wird dazu benutzt, die aufeinanderfolgenden gleichen Codesequenzen der ersten Spur voneinander zu unterscheiden, sie also zu codieren. Die absolute Position ist durch die Kombination von Teilpositionen innerhalb der jeweiligen Codesequenzen der beiden Spuren an jeder Position innerhalb des Messbereiches eindeutig Eine ähnliche Positionscodierung ist aus EP 0800725 B1 bekannt. Nachteilig bei dieser Positionscodierung ist, dass durch die unterschiedlichen Breiten der Codeelemente der beiden Spuren die eindeutige Zuordnung der in den beiden Spuren ermittelten Teilpositionen relativ aufwendig ist. Weiterhin sind aufgrund der unterschiedlichen Breiten der Codeelemente unterschiedlich gestaltete Detektoreinheiten erforderlich.

Aufgabe der Erfindung ist es, eine einfache absolute Positionscodierung für eine Positionsmessvorrichtung anzugeben, mit der große Messbereiche absolut codiert werden können.

Diese Aufgabe wird durch die im Patentanspruch 1 angegebene Positionscodierung gelöst.

Diese Positionscodierung weist parallel zueinander angeordnete und in Messrichtung verlaufende Codespuren auf, wobei

die eine Codespur mehrfach aufeinanderfolgend eine erste Codesequenz aufweist, die aus einer Mehrzahl von Codeelementen besteht,

die andere Codespur mehrfach aufeinanderfolgend eine zweite Codesequenz aufweist, die aus einer Mehrzahl von Codeelementen besteht,

die Codesequenzen der einen Codespur und der anderen Codespur unterschiedliche Längen aufweisen, und

die Codeelemente der einen Codespur und der anderen Codespur jeweils in Messrichtung gleiche Abmessungen aufweisen.

Unterschiedliche Längen bedeutet dabei, dass die Länge der einen Codesequenz von der Länge der anderen Codesequenz abweicht, also die eine Codesequenz eine Anzahl von Codeelementen aufweist, die von der Anzahl der Codeelemente der anderen Codesequenz abweicht.

Innerhalb des absolut zu bestimmenden Messbereichs sind somit mehrere erste Codesequenzen in der einen Codespur sowie mehrere zweite Codesequenzen in der weiteren Codespur angeordnet.

Besonders vorteilhaft ist es dabei, wenn die Länge der einen Codesequenz sich von der Länge der anderen Codesequenz um 1 unterscheidet. Dabei bedeutet die Länge eine ganzzahlige Anzahl von Codeelementen.

Eine besonders einfache Auswertung ergibt sich, wenn die kürzere der beiden Codesequenzen ein Teil der längeren der beiden Codesequenzen ist.

Die Erfindung ist nicht auf zwei Codespuren beschränkt, analog zu den zwei erwähnten Codespuren kann eine dritte Codespur vorgesehen sein, die zur zweiten Codespur in analoger Weise abgestuft ist, wie die zweite Codespur zur ersten Codespur.

Die Positionscodierung kann bei Winkelmessvorrichtungen eingesetzt werden, ist aber bei Längenmessvorrichtungen besonders vorteilhaft einsetzbar, da hier vermehrt die Aufgabe besteht, den absolut zu codierenden Messbereich zu vergrößern.

Weiterhin soll mit der Erfindung eine absolute Positionsmessvorrichtung angegeben werden, mit der relativ große Messbereiche absolut gemessen werden können und die Positionsermittlung relativ einfach möglich ist.

Diese Aufgabe wird mit einer Positionsmessvorrichtung mit den Merkmalen des Anspruchs 6 gelöst.

Diese Positionsmessvorrichtung weist parallel zueinander angeordnete und in Messrichtung verlaufende Codespuren auf, wobei

die eine Codespur mehrfach aufeinanderfolgend eine erste Codesequenz aufweist, die aus einer Mehrzahl von Codeelementen besteht,

die weitere Codespur mehrfach aufeinanderfolgend eine zweite Codesequenz aufweist, die aus einer Mehrzahl von Codeelementen besteht, die Codesequenzen der einen Codespur und der weiteren Codespur unterschiedliche Längen aufweisen, und

die Codeelemente der einen Codespur und der anderen Codespur jeweils in Messrichtung gleiche Abmessungen aufweisen.

Weiterhin weist die Positionsmessvorrichtung eine Abtasteinheit zur Abtastung der Positionscodierung und eine Auswerteeinheit zur Bildung jeweils einer Teilposition der Codesequenzen und eines Positionsmesswertes aus den Teilpositionen auf.

Die Abtasteinheit weist eine erste Detektoreinheit zur Abtastung der einen Codespur und eine zweite Detektoreinheit zur Abtastung der anderen Codespur auf. Vorteilhaft ist es dabei, wenn die erste Detektoreinheit zur Abtastung der einen Codespur und die zweite Detektoreinheit zur Abtastung der anderen Codespur jeweils gleichartig ausgebildet sind.

Weitere vorteilhafte Ausgestaltungen der Erfindung sind in den abhängigen Ansprüchen und der nachfolgenden Beschreibung angegeben.

Anhand der Zeichnungen werden Ausführungsbeispiele der Erfindung näher erläutert.

Es zeigt

Figur 1      eine Positionscodierung einer Längenmessvorrichtung in schematischer Darstellung;

Figur 2      eine Abtasteinrichtung zur Abtastung der Positionscodierung gemäß Figur 1 mit einer Auswerteeinheit;

Figur 3      ein Flussdiagramm und Rechenvorschriften zur Ermittlung der Position mittels der Positionscodierung;

Figur 4      ein Diagramm zur Ermittlung der Position aus gelesenen Bitpattern (Wörtern) anhand eines Beispiels der Positionscodierung;

Figur 5      eine weitere Längenmessvorrichtung in schematischer Darstellung;

Figur 6      ein Flussdiagramm und Rechenvorschriften zur Ermittlung der Position mittels einer weiteren Positionscodierung, und

Figur 7      ein Diagramm zur Ermittlung der Position aus gelesenen Bitpattern (Wörtern) anhand eines Beispiels der weiteren Positionscodierung.

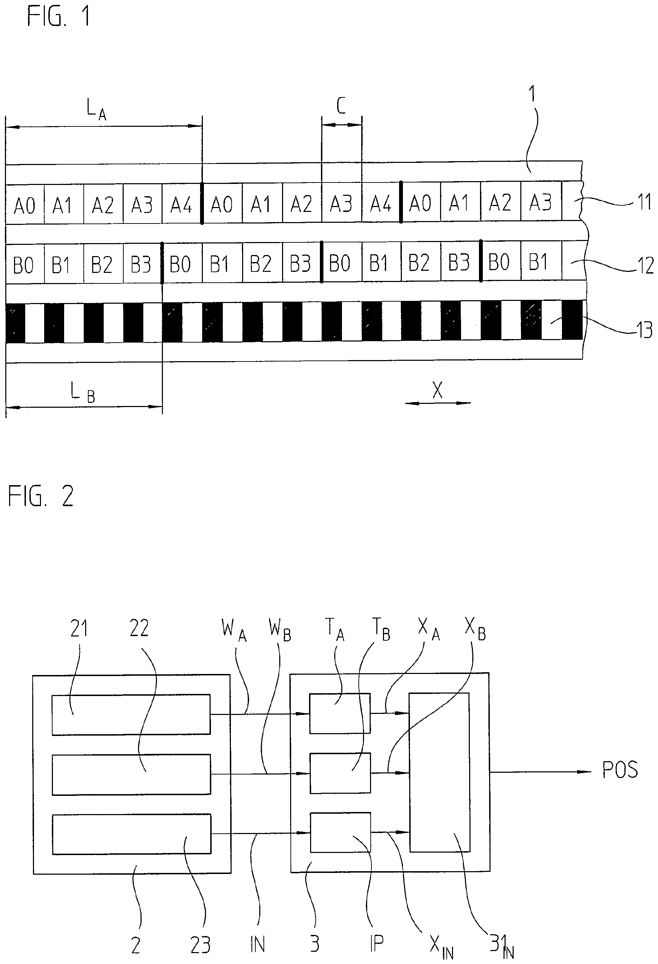

Figur 1 zeigt ein Beispiel einer absoluten Positionscodierung 1 in Form eines Maßstabs. Die Positionscodierung 1 besteht zumindest aus einer ersten Codespur 11 und einer zweiten Codespur 12. Diese zwei Codespuren 11 und 12 sind parallel zueinander und in Messrichtung X verlaufend angeordnet.

Die erste Codespur 11 besteht aus einer Abfolge von ersten Codesequenzen A. Die erste Codesequenz A besteht aus Codeelementen A0 bis A4 mit der Breite C. An jede der Codesequenz A schließt sich der Anfang dieser Codesequenz A wieder an, so dass an jeder Nahtstelle der aufeinanderfolgenden Codesequenzen A diese Codesequenz A zyklisch fortgesetzt ist.

Die zweite Codespur 12 besteht aus einer Abfolge von zweiten Codesequenzen B. Diese zweite Codesequenz B besteht aus Codeelementen B0 bis B3, ebenfalls mit der Breite C, die derart angeordnet sind, dass sie zu den Codeelementen der ersten Codesequenz A fluchten. An jede der Codesequenz B schließt sich der Anfang dieser Codesequenz B wieder an, so dass an jeder Nahtstelle der aufeinanderfolgenden Codesequenzen B diese Codesequenz B zyklisch fortgesetzt ist.

Eine Codesequenz A, B ist dabei eine Abfolge von Codeelementen, bei der eine vorgegebene Anzahl aufeinanderfolgender Codeelemente, später Abtastlänge bezeichnet, über die gesamte Codesequenz unterschiedliche und somit eindeutig voneinander unterscheidbare Kombinationen von Bits, später Codewörter bezeichnet, ergibt.

Die erste Codesequenz A hat die Länge $L_A$ und die zweite Codesequenz B die Länge $L_B$, wobei die Länge $L_A$, $L_B$ jeweils die Anzahl der Codeelemente einer Codesequenz A, B bedeutet. Die beiden Längen $L_A$ und $L_B$ unterscheiden sich voneinander.

Das Prinzip der Positionsmessung beruht auf der Schwebung von mehreren Codesequenzen A, B unterschiedlicher Längen $L_A$ und $L_B$, wobei $L_A$ und $L_B$ ganzzahlig und vorzugsweise teilerfremd.

Mit diesen zwei Codesequenzen A, B können K mögliche Positionen eindeutig codiert werden, wobei die Anzahl K = KGV ($L_A$, $L_B$) ist, mit

KGV = kleinstes gemeinsames Vielfaches von $L_A$ und $L_B$
$L_A$ = Länge der ersten Codesequenz A;
$L_B$ = Länge der zweiten Codesequenz B.

Der maximale Messbereich (also die maximale Länge in Messrichtung X, nach der sich das Bitmuster der beiden Spuren 11 und 12 wiederholt) ist mit zwei Codesequenzen A, B absolut codierbar, wenn sich die Länge $L_A$ von der Länge $L_B$ um 1 unterscheidet:

$$K_{max} = L_A * L_B$$

Zur Positionsmessung wird die Positionscodierung 1 beispielsweise optisch abgetastet, indem die Codeelemente der Codesequenzen A, B ein Lichtbündel positionsabhängig modulieren, so dass am Ort einer Detektoreinheit 21, 22 einer Abtasteinheit 2 eine positionsabhängige Lichtverteilung entsteht, die von der Detektoreinheit 21, 22 in elektrische Abtastsignale $W_A$, $W_B$ gewandelt wird. Die Detektoreinheit 21 zur Abtastung der ersten Codespur 11 sowie die Detektoreinheit 22 zur Abtastung der zweiten Codespur 12 ist jeweils ein Zeilensensor, mit einer in Messrichtung X angeordneten Folge von Detektorelementen. Die Detektorelemente sind derart ausgebildet, dass jedem der Codeelemente in jeder Relativlage zumindest eines der Detektorelemente eindeutig zugeordnet ist, und somit aus jedem der Codeelemente ein Bit 0 oder 1 gewonnen werden kann. Hierzu sind beim optischen Abtastprinzip die Codeelemente reflektierend oder nichtreflektierend, bzw. opak oder nichtopak, wobei den reflektierenden Codeelementen beispielsweise der Bitwert 1 und den nichtreflektierenden Codeelementen der Bitwert 0 zugeordnet wird. Die Abfolge dieser Bits innerhalb einer Codesequenz A, B bildet für die beiden Codesequenzen A, B jeweils ein Codewort $W_A$, $W_B$. Die Abtastsignale, also die Codeworte $W_A$, $W_B$, werden einer Auswerteeinheit 3 zur Bildung eines Positionsmesswertes POS zugeführt. Konkret werden die Codeworte $W_A$, $W_B$ jeweils der entsprechenden Decodiereinrichtung $T_A$, $T_B$ zugeführt, welche aus jedem der Codeworte $W_A$, $W_B$ einer der Codesequenzen A, B eine Teilposition $X_A$, $X_B$ ableitet und mit Hilfe dieser Teilpositionen $X_A$, $X_B$ dann daraus eine absolute Position POS bildet. Bei einer Verschiebung der Abtasteinheit 2 gegenüber der Positionscodierung 1 um die Breite C bzw. Länge eines Codeelementes wird aus jeder der Codesequenzen A, B jeweils ein neues Codewort $W_A$, $W_B$ erzeugt.

Die erste Detektoreinheit 21 zur Abtastung der ersten Codespur 11 und die zweite Detektoreinheit 22 zur Abtastung der zweiten Codespur 12 sind vorzugsweise gleichartig ausgebildet und somit als Standardbaustein in großen Stückzahlen kostengünstig herstellbar.

Zur Decodierung der Codewörter $W_A$, $W_B$ sind die zwei Tabellen $T_A$, $T_B$ vorgesehen, die Tabelle $T_A$ für die Codesequenz A und die Tabelle $T_B$ für die Codesequenz B. Eine bestimmte Anzahl von Codeelementen wird zur Generierung der Codewörter $W_A$, $W_B$ mittels der Abtasteinheit 2 gleichzeitig abgetastet. Die Anzahl der abgetasteten Codeelemente jeweils einer Codesequenz A, B wird Abtastlänge $L_L$ bezeichnet.

Die Codesequenzen A und B, also die Abfolge der Codeelemente, sowie die Abtastlänge $L_L$ sind derart gewählt, dass innerhalb des Abschnitts $L_A$ an jeder Position in Schritten der Breite C ein eindeutiges Wort $W_A$ generiert wird, das sich von allen anderen Wörtern dieses Abschnitts $L_A$ unterscheidet, und dass innerhalb des Abschnitts $L_B$ an jeder Position in Schritten der Breite C ein eindeutiges Wort $W_B$ generiert wird, das sich von allen anderen Worten dieses Abschnitts $L_B$ unterscheidet.

Mit der in Figur 1 beispielhaft dargestellten Positionscodierung 1 einer Längenmesseinrichtung ergibt sich somit:

Länge der Codesequenz A: $L_A$ = 5
Codesequenz A: $A_0A_1A_2A_3A_4$
Länge der Codesequenz B: $L_B$ = 4
Codesequenz B: $B_0B_1B_2B_3$
Abtastlänge: $L_L$ = 4

$$K_{max} = L_A * L_B = 20$$

Die Tabelle $T_A$ für die Codesequenz A:

| Bitpattern | Wort $W_A$ | Teilposition $X_A$ |
|---|---|---|
| $A_0A_1A_2A_3$ | $W_{A0}$ | 0 |
| $A_1A_2A_3A_4$ | $W_{A1}$ | 1 |
| $A_2A_3A_4A_0$ | $W_{A2}$ | 2 |
| $A_3A_4A_0A_1$ | $W_{A3}$ | 3 |
| $A_4A_0A_1A_2$ | $W_{A4}$ | 4 |

Die Tabelle $T_B$ für die Codesequenz B:

| Bitpattern | Wort $W_B$ | Teilposition $X_B$ |
|---|---|---|
| $B_0B_1B_2B_3$ | $W_{B0}$ | 0 |
| $B_1B_2B_3B_0$ | $W_{B1}$ | 1 |
| $B_2B_3B_0B_1$ | $W_{B2}$ | 2 |
| $B_3B_0B_1B_2$ | $W_{B3}$ | 3 |

(fortgesetzt)

| Bitpattern | Wort $W_B$ | Teilposition $X_B$ |
|---|---|---|
| 1000 | $W_{B1}$ | 1 |
| 0001 | $W_{B2}$ | 2 |
| 0010 | $W_{B3}$ | 3 |

Diese beiden Tabellen $T_A$, $T_B$ beinhalten zusammen 9 Einträge, mit diesen 9 Einträgen sind 20 verschiedene Positionen POS eindeutig decodierbar, und zwar in Schritten entsprechend einer Breite C eines Codeelementes.

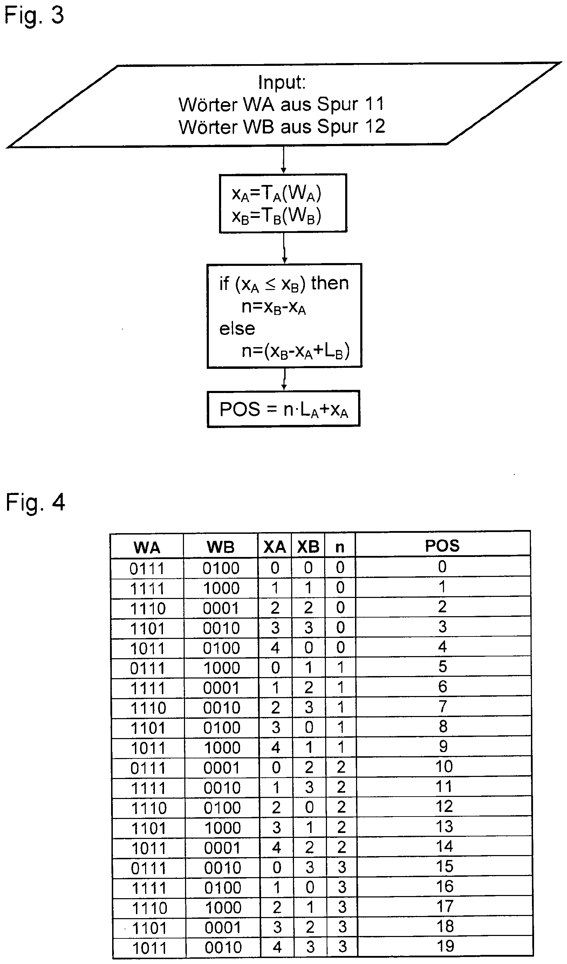

Ein Algorithmus zur Ermittlung der Positionen POS aus den Teilpositionen $X_A$, $X_B$ ist in Figur 3 beispielhaft dargestellt.

Der Vorteil einer derartigen Codierung besteht darin, dass eine Decodiereinrichtung in Form von Tabellen $T_A$ und $T_B$ jeweils nur die relativ kurzen seriellen Codesequenzen A und B decodieren müssen. Erfolgt die Decodierung mittels Tabellen, sind nur mehrere kleine Tabellen erforderlich. Es sind sehr viel weniger Tabelleneinträge notwendig, als absolute Positionen ausgebbar sind.

Anhand eines konkreten Beispiels wird die Erfindung noch näher erläutert:

Länge der Codesequenz A: $L_A = 5$
Codesequenz A: 01111
Länge der Codesequenz B: $L_B = 4$
Codesequenz B: 0100
Abtastlänge: $L_L = 4$ in jeder der beiden Codespuren 11 und 12

$$K_{max} = L_A * L_B = 20$$

Codespur 11: 01111011110111101111
Codespur 12: 01000100010001000100

Die Tabelle $T_A$ für die Codesequenz A:

| Bitpattern | Wort $W_A$ | Teilposition $X_A$ |
|---|---|---|
| 0111 | $W_{A0}$ | 0 |
| 1111 | $W_{A1}$ | 1 |
| 1110 | $W_{A2}$ | 2 |
| 1101 | $W_{A3}$ | 3 |
| 1011 | $W_{A4}$ | 4 |

Die Tabelle $T_B$ für die Codesequenz B:

| Bitpattern | Wort $W_B$ | Teilposition $X_B$ |
|---|---|---|
| 0100 | $W_{B0}$ | 0 |

Ein Diagramm zur Ermittlung der Positionen POS bei diesem konkreten Beispiel ist in Figur 4 dargestellt. Dabei sind in den ersten beiden Spalten die bei unterschiedlichen Momentanpositionen abgetasteten Bitpattern (Wörter) $W_A$ und $W_B$ eingetragen. In den nächsten beiden Spalten sind die mittels der Tabellen $T_A$, $T_B$ ermittelten Teilpositionen $X_A$, $X_B$ angeführt. Die nächste Spalte enthält den nach den in Figur 3 angegebenen Regeln berechneten Wert n und die rechte Spalte enthält die nach dem in Figur 3 angegebenen Algorithmus ermittelte Position POS.

Die Decodiereinrichtungen $T_A$ und $T_B$ sind vorteilhaft als ASIC ausgebildet, wobei die erforderlichen Tabellen T, also die erforderlichen Wertevorräte, jeweils bei der Fertigung des ASIC's fest verdrahtet ausgebildet sind. Alternativ können die Tabellen T bzw. Wertevorräte aber auch in Festwertspeichern, wie EPROM abgelegt sein.

Soll der durch die beiden Codespuren 11 und 12 ermittelte Positionsmesswert weiter aufgelöst werden, können noch weitere Spuren mit absoluten Codierungen oder mit Inkrementalteilungen vorgesehen sein. Im Beispiel ist parallel zu den Codespuren 11 und 12 eine Inkrementalspur 13 angeordnet, deren Teilungsperiode der Breite C eines Codeelementes der Codespuren 11 und 12 entspricht. Durch entsprechende Dimensionierung der Inkrementalspur 13 ist es möglich, die Breite C eines Codeelementes weiter zu unterteilen. Hierzu wird die Inkrementalteilung 13 mittels einer Detektoreinheit 23 abgetastet, die in bekannter Weise mehrere gegeneinander phasenverschobene Inkrementalsignale IN erzeugt. Diese Inkrementalsignale IN werden einer Interpolationseinheit IP zugeführt, welche die Inkrementalsignale IN weiter unterteilt und eine absolute Teilposition $X_{IN}$ innerhalb der Breite C ausgibt. Die Teilpositionen $X_A$, $X_B$, $X_{IN}$ werden einer Kombinationseinheit 31 zugeführt, welche daraus die Position POS bildet, die über den Messbereich absolut und eindeutig ist und eine Auflösung entsprechend dem Interpolationsschritt der Teilposition $X_{IN}$ aufweist.

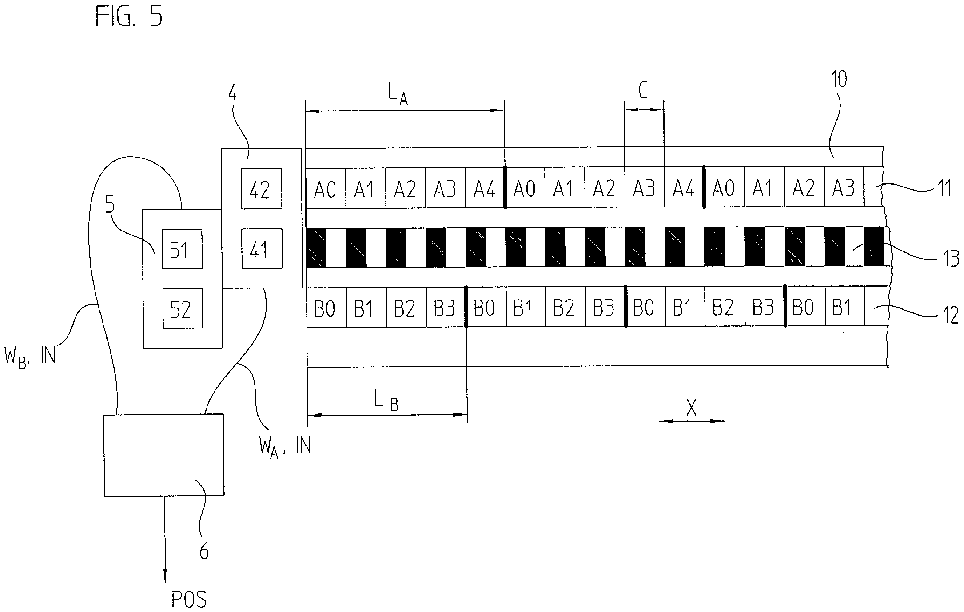

In Figur 5 ist eine besonders vorteilhafte Ausgestaltung einer absoluten Positionsmessvorrichtung dargestellt. Auf einer Seite der Inkrementalspur 13 ist die erste Codespur 11 angeordnet und auf der anderen Seite der Inkrementalspur 13 ist die Codespur 12 angeordnet. Bei dieser Anordnung ist es nun möglich eine Abtasteinheit bestehend aus zwei gleichartigen Abtasteinrichtungen 4 und 5 zu verwendet. Jede der Abtasteinrichtungen 4 und 5 besteht aus einer Detektoreinheit 41 bzw. 51 zur Abtastung der Inkrementalspur 13 sowie Detektoreinheit 42 bzw. 52 zur Abtastung jeweils einer der Codespuren 11 bzw. 12. Die Detektoreinheiten 41 und 51 sind identisch und die Detektoreinheiten 42 und 52 sind identisch. Die Abtasteinrichtung 4 ist mit der Abtasteinrichtung 5 identisch, die Abtasteinrichtung 4 ist gegenüber der Abtasteinrichtung 5 nur um 180° gedreht angeordnet. Bei der Auswertung der Abtastsignale $W_B$ muss muss diese Verdrehung der Abtasteinrichtung 5 entsprechend berücksichtigt werden.

Die Abtastsignale IN, $W_A$, $W_B$ werden einer Auswerteeinheit 6 zur Bildung der Position POS mittels der Tabellen $T_A$, $T_B$ entsprechend der oben erläuterten Regeln zugeführt.

Die Erfindung ist beim optischen Abtastprinzip besonders vorteilhaft einsetzbar, da eine optisch abtastbare Positionscodierung 1 mit maximal möglich verschiedenen Positionen reproduzierbar herstellbar ist und damit eine besonders hochauflösende Positionsmessung ermöglicht wird. Dabei können bei dem Beispiel gemäß Figur 1 die Detektoreinheiten 21, 22, die Decodiereinrichtungen in Form der Tabellen $T_A$, $T_B$, sowie die Kombinationseinheit 31 gemeinsam in einem Opto-ASIC untergebracht sein. Dieses Opto-ASIC beinhaltet vorzugsweise zusätzlich auch die Detektoreinheit 23 sowie die Interpolationseinheit IP.

Die Erfindung ist aber nicht auf das optische Abtastprinzip beschränkt, sondern auch bei magnetischen, induktiven sowie kapazitiven Abtastprinzipien einsetzbar.

Eine einfache Auswertung ergibt sich, wenn die kürzere der Codesequenzen ein Teil der längeren der Codesequenzen ist. Im erörterten Beispiel würde dies bedeuten, dass die Abfolge der Codeelemente A0 bis A3 der Abfolge der Codeelemente B0 bis B3 entspricht. Die zur Decodierung erforderliche Tabelle $T_A$ entspricht dabei der Tabelle $T_B$, so dass für diesen Bereich für beide Codesequenzen A, B nur eine gemeinsame Tabelle erforderlich ist. Zur vollständigen Decodierung müssen dann nur noch für die zyklischen Fortsetzungen der Codesequenzen A und B individuelle Tabellen geschaffen werden.

Dass sich die Längen der Codesequenzen um 1 unterscheiden, ist besonders vorteilhaft. Es liegt aber auch im Rahmen der Erfindung, wenn sich die beiden Codesequenzen in ihren Längen beispielsweise um eine Potenz von 2 unterscheiden. Bei einer derartigen Abstufung kann die Auswertung besonders einfach realisiert werden, da binäre Berechnungen einfach durchführbar sind.

Anhand eines konkreten Beispiels hierzu wird die Erfindung noch näher erläutert:

Länge der Codesequenz A: $L_A = 6$
Codesequenz A: 011110
Länge der Codesequenz B: $L_B = 4$
Codesequenz B: 0100
Abtastlänge: $L_L = 4$ in jeder der beiden Codespuren

$$K_{max} = KGV (L_A , L_B) = 12$$

erste Spur aus Codesequenz A: 011110011110
zweite Spur aus Codesequenz B: 010001000100

Tabelle $T_A$: für die Codesequenz A

| Bitpattern | Wort $W_A$ | Teilposition $X_A$ |
|---|---|---|
| 0111 | $w_{A0}$ | 0 |
| 1111 | $w_{A1}$ | 1 |
| 1110 | $w_{A2}$ | 2 |
| 1100 | $w_{A3}$ | 3 |
| 1001 | $w_{A4}$ | 4 |
| 0111 | $w_{A5}$ | 5 |

Tabelle $T_B$: für die Codesequenz B

| Bitpattern | Wort $W_B$ | Teilposition $X_B$ |
|---|---|---|
| 0100 | $w_{B0}$ | 0 |
| 1000 | $w_{B1}$ | 1 |
| 0001 | $w_{B2}$ | 2 |
| 0010 | $w_{B3}$ | 3 |

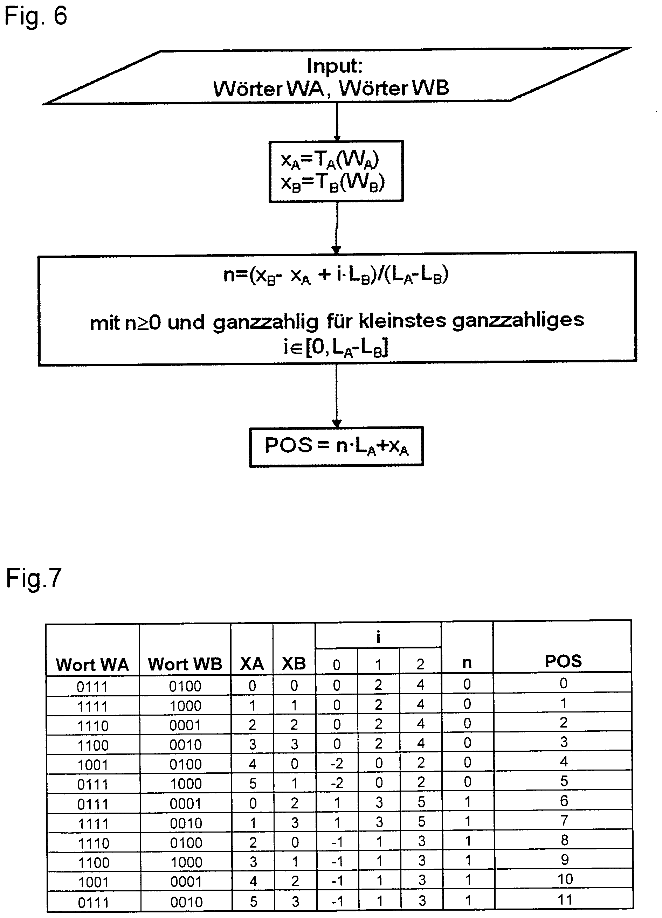

Ein Algorithmus zur Ermittlung der Positionen POS aus den Teilpositionen $X_A$, $X_B$ ist in Figur 6 beispielhaft dargestellt.

Ein Diagramm zur Ermittlung der Position POS bei diesem konkreten Beispiel ist in Figur 7 dargestellt.

Die Erfindung ist anhand von Beispielen mit zwei Codesequenzen A, B in den zwei Codespuren 11 und 12 erläutert. Um einen noch größeren Messbereich absolut zu codieren, können auch mehr als zwei Codesequenzen in mehr als zwei Spuren angeordnet werden.

**Patentansprüche**

1. Absolute Positionscodierung für eine Positionsmessvorrichtung, mit parallel zueinander angeordneten und in Messrichtung (X) verlaufenden Codespuren (11, 12), wobei
die eine Codespur (11) mehrfach aufeinanderfolgend eine erste Codesequenz (A) aufweist, die aus einer Mehrzahl von Codeelementen besteht,
die andere Codespur (12) mehrfach aufeinanderfolgend eine zweite Codesequenz (B) aufweist, die aus einer Mehrzahl von Codeelementen besteht,
die Länge ($L_A$) der einen Codesequenz (A) von der Länge ($L_B$) der anderen Codesequenz (B) abweicht, wobei die Länge ($L_A$, $L_B$) jeweils die ganzzahlige Anzahl der Codeelemente der Codesequenz (A, B) bedeutet, die Codeelemente der einen Codesequenz (A) und die Codeelemente der anderen Codesequenz (B) in Messrichtung (X) die gleiche Abmessung (C) aufweisen.

2. Absolute Positionscodierung nach Anspruch 1, **dadurch gekennzeichnet, dass** sich die Länge ($L_A$) der einen Codesequenz (A) von der Länge ($L_B$) der anderen Codesequenz (B) um 1 unterscheidet.

3. Absolute Positionscodierung nach Anspruch 1, **dadurch gekennzeichnet, dass** sich die beiden Codesequenzen in ihrer Länge um eine Potenz von 2 unterscheiden.

4. Absolute Positionscodierung nach einem der vorhergehenden Ansprüche, **dadurch gekennzeichnet, dass** die kürzere der beiden Codesequenzen (B) ein Teil der längeren der Codesequenzen (A) ist.

5. Absolute Positionscodierung nach einem der vorhergehenden Ansprüche, **dadurch gekennzeichnet, dass** zusätzlich zu den Codespuren (11, 12) zumindest eine Inkrementalspur (13) angeordnet ist.

6. Absolute Positionsmessvorrichtung mit
einer absoluten Positionscodierung (1, 10) nach einem der Ansprüche 1 bis 5, bestehend aus zwei parallel zueinander angeordneten und in Messrichtung (X) verlaufenden Codespuren (11, 12), wobei
die eine Codespur (11) mehrfach aufeinanderfolgend eine erste Codesequenz (A) aufweist, die aus einer Mehrzahl von Codeelementen besteht,
die andere Codespur (12) mehrfach aufeinanderfolgend eine zweite Codesequenz (B) aufweist, die aus einer Mehrzahl von Codeelementen besteht,
die Codesequenzen (A, B) der einen Codespur (11) und der anderen Codespur (11) unterschiedliche Längen ($L_A$, $L_B$) aufweisen, wobei die Länge ($L_A$, $L_B$) jeweils die ganzzahlige Anzahl der Codeelemente der Codesequenz (A, B) bedeutet, die Codeelemente der einen Codespur (11) und der anderen Codespur (11) in Messrichtung (X) die gleiche Abmessung (C) aufweisen, und
mit
einer Abtasteinheit (2, 4, 5) zur Abtastung der Positionscodierung (1, 10) und zur Bildung von Wörtern (W), sowie mit
einer Auswerteeinheit (3, 6) zur Bildung eines Positionsmesswertes (POS) aus den Wörtern (W).

7. Absolute Positionsmessvorrichtung nach Anspruch 6, **dadurch gekennzeichnet, dass** die Abtasteinheit (2, 4, 5) eine erste Detektoreinheit (21, 42) zur Abtastung der einen Codespur (11) und eine zweite Detektoreinheit (22, 52) zur Abtastung der anderen Codespur (12) aufweist, wobei die beiden Detektoreinheiten (21, 22, 42, 52) gleichartig ausgebildet sind.

8. Absolute Positionsmessvorrichtung nach einem der vorhergehenden Ansprüche 6 oder 7, **dadurch gekennzeichnet, dass** parallel zu den Codespuren (11, 12) zumindest eine Inkrementalspur (13) angeordnet ist.

9. Absolute Positionsmessvorrichtung nach Anspruch 8, **dadurch gekennzeichnet,** die Auswerteeinheit (3, 6) eine Kombinationseinheit (31) aufweist, die dazu ausgebildet ist, aus den durch Abtastung der Codespuren (11, 12) gewonnenen Wörtern (W) und aus durch Abtastung der Inkrementalspur (13) gewonnenen Inkrementalsignalen (IN) den Positionsmesswert (POS) zu bilden.

10. Absolute Positionsmessvorrichtung nach einem der vorhergehenden Ansprüche 8 oder 9, **dadurch gekennzeichnet, dass** die eine Codespur (11) auf einer Seite neben der Inkrementalspur (13) und die andere Codespur (12) auf der anderen Seite neben der Inkrementalspur (13) angeordnet ist.

11. Absolute Positionsmessvorrichtung nach Anspruch 10, **dadurch gekennzeichnet, dass** die Abtasteinheit eine erste Abtasteinrichtung (4) und eine zweite Abtasteinrichtung (5) umfasst, wobei die beiden Abtasteinrichtungen (4, 5) gleichartig ausgebildet sind, indem die erste Abtasteinrichtung (4) eine Detektoreinheit (42) zur Abtastung der einen Codespur (11) sowie eine Detektoreinheit (41) zur Abtastung der Inkrementalspur (13) umfasst und die zweite Abtasteinrichtung (5) eine Detektoreinheit (52) zur Abtastung der anderen Codespur (12) sowie eine Detektoreinheit (51) zur Abtastung der Inkrementalspur (13) umfasst.

**Claims**

1. Absolute position code for a position measuring device, having code tracks (11, 12) arranged parallel to each other and extending in the measuring direction (X), wherein
the one code track (1) has a first code sequence (A) many times in succession, which comprises a plurality of code elements,
the other code track (12) has a second code sequence (B) many times in succession, which comprises a plurality of code elements,
the length ($L_A$) of the one code sequence (A) differs from the length ($L_B$) of the other code sequence (B), wherein the length ($L_A$, $L_B$) respectively signifies the integer number of the code elements of the code sequence (A, B),
the code elements of the one code sequence (A) and the code elements of the other code sequence (B) have the same dimension (C) in the measuring direction (X).

2. Absolute position code according to Claim 1, **characterized in that** the length ($L_A$) of the one code sequence (A) differs from the length ($L_B$) of the other code sequence (B) by 1.

3. Absolute position code according to Claim 1, **characterized in that** the two code sequences differ in their length by a power of 2.

4. Absolute position code according to one of the preceding claims, **characterized in that** the shorter of the two code sequences (B) is part of the longer code sequence (A).

5. Absolute position code according to one of the preceding claims, **characterized in that** at least one incremental track (13) is arranged in addition to the code tracks (11, 12).

6. Absolute position measuring device having an absolute position code (1, 10) according to one of Claims 1 to 5,
comprising two code tracks (11, 12) arranged parallel to each other and extending in the measuring direction (X), wherein
the one code track (11) has a first code sequence (A) many times in succession, which comprises a plurality of code elements,
the other code track (12) has a second code sequence (B) many times in succession, which comprises a plurality of code elements,
the code sequences (A, B) of the one code track (11) and the other code track (11) have different lengths ($L_A$, $L_B$), wherein the length ($L_A$, $L_B$) respectively signifies the integer number of the code elements of the code sequence (A, B),
the code elements of the one code sequence (11) and the code elements of the other code sequence (11) have the same dimension (C) in the measuring direction (X), and
having a scanning unit (2, 4, 5) for scanning the position code (1, 10) and for forming words (W), and having
an evaluation unit (3, 6) for forming a position measured value (POS) from the words (W).

7. Absolute position measuring device according to Claim 6, **characterized in that** the scanning unit (2, 4, 5) has a first detector unit (21, 42) for scanning the one code track (11) and a second detector unit (22, 52) for scanning the other code track (12), wherein the two detector units (21, 22, 42, 52) are formed identically.

8. Absolute position measuring device according to one of the preceding Claims 6 or 7, **characterized in that** at least one incremental track (13) is arranged parallel to the code tracks (11, 12).

9. Absolute position measuring device according to Claim 8, **characterized in that** the evaluation unit (3, 6) has a combination unit (31), which is designed to form the position measured value (POS) from the words (W) obtained by scanning the code tracks (11, 12) and from incremental signals (IN) obtained by scanning the incremental track (13).

10. Absolute position measuring device according to one of the preceding Claims 8 or 9, **characterized in that** the one code track (11) is arranged on one side beside the incremental track (13), and the other code track (12) is arranged on the other side beside the incremental track (13).

11. Absolute position measuring device according to Claim 10, **characterized in that** the scanning unit comprises a first scanning device (4) and a second scanning device (5), wherein the two scanning devices (4, 5) are formed identically, **in that** the first scanning device (4) comprises a detector unit (42) for scanning the one code track (11) and a detector unit (41) for scanning the incremental track (13), and the second scanning device (5) comprises a detector unit (52) for scanning the other code track (12) and a detector unit (51) for scanning the incremental track (13).

**Revendications**

1. Codage de position absolue destiné à un dispositif de mesure de position, comportant des pistes de codage (11, 12) disposées parallèlement l'une à l'autre et s'étendant dans la direction de mesure (X), dans lequel
ladite piste de codage (11) comporte une première séquence de codage (A) répétée consécutivement de multiples fois, qui est constituée d'une pluralité d'éléments de code,
l'autre piste de codage (12) comporte une seconde séquence de codage (B) répétée consécutivement de multiples fois, qui est constituée d'une pluralité d'éléments de code,
la longueur ($L_A$) de ladite séquence de code (A) est différente de la longueur ($L_B$) de l'autre séquence de code (B), dans lequel la longueur ($L_A$, $L_B$) représente respectivement le nombre entier des éléments de code de la séquence de code (A, B),
les éléments de code de ladite séquence de code (A) et les éléments de code de l'autre séquence de code (B) présentent la même dimension (C) dans la direction de mesure (X).

15     **EP 2 342 539 B1**   16

2. Codage de position absolue selon la revendication 1, **caractérisé en ce que** la longueur (L_A) de ladite séquence de code (A) diffère de 1 de la longueur (L_B) de l'autre séquence de code (B).

3. Codage de position absolue selon la revendication 1, **caractérisé en ce que** les deux séquence de code ont des longueurs qui diffèrent d'une puissance de 2.

4. Codage de position absolue selon l'une quelconque des revendications précédentes, **caractérisé en ce que** la plus courte des deux séquences de code (B) est une partie de la plus longue des séquences de code (A).

5. Codage de position absolue selon l'une quelconque des revendications précédentes, **caractérisé en ce qu'**il est prévu au moins une piste incrémentielle (13) en plus des pistes de code (11, 12).

6. Dispositif de mesure de position absolue comportant un codage de position absolue (1, 10) selon l'une quelconque des revendications 1 à 5, constitué de deux pistes de code (11, 12) disposées parallèlement l'une à l'autre et s'étendant dans la direction de mesure (X), dans lequel

ladite piste de code (11) comporte une première séquence de code (A) répétée consécutivement de multiples fois, qui est constituée d'une pluralité d'éléments de code,

l'autre piste de code (12) comporte une seconde séquence de code (B) répétée consécutivement de multiples fois, qui est constituée d'une pluralité d'éléments de code,

les séquences de code (A, B) de ladite piste de code (11) et de l'autre piste de code (11) présentent des longueurs (L_A, L_B) différentes,

dans lequel les longueurs (L_A, L_B) représentent respectivement le nombre entier des éléments de code de la séquence de code (A, B),

les éléments de code de ladite piste de code (11) et de l'autre piste de code (11) présentent la même dimension (C) dans la direction de mesure (X), et comportant une unité d'échantillonnage (2, 4, 5) destinée à échantillonner le codage de position (1, 10) et à former des mots (W) et compotant également une unité d'évaluation. (3, 6) destinée à déterminer la valeur de position (POS) à partir des mots (W).

7. Dispositif de mesure de position absolue selon la revendication 6, **caractérisé en ce que** l'unité d'échantillonnage (2, 4, 5) comporte une première unité de détection (21, 42) destinée à échantillonner ladite piste de code (11) et une seconde unité de détection (22,52) destinée à échantillonner l'autre piste de code (12), dans lequel les deux unités de détection (21, 22, 42, 52) sont réalisées de la même manière.

8. Dispositif de mesure de position absolue selon l'une quelconque des revendications 6 ou 7 précédentes, **caractérisé en ce qu'**au moins une piste incrémentielle (13) est disposée parallèlement aux pistes de code (11, 12).

9. Dispositif de mesure de position absolue selon la revendication 8, **caractérisé en ce que** l'unité d'évaluation (3, 6) comporte une unité de combinaison (31) qui est réalisée de manière à déterminer la valeur de position (POS) à partir des mots (W) obtenus par échantillonnage des pistes de code (11, 12) et à partir de signaux incrémentiels (IN) obtenus par échantillonnage de la piste incrémentielle (13).

10. Dispositif de mesure de position absolue selon l'une quelconque des revendications 8 ou 9 précédentes, **caractérisé en ce que** ladite piste de code (11) est disposée sur un côté contigu à la piste incrémentielle (13) et **en ce que** l'autre piste de code (12) est disposée sur l'autre côté contigu à la piste incrémentielle (13).

11. Dispositif de mesure de position absolue selon la revendication 10, **caractérisé en ce que** l'unité d'échantillonnage comprend un premier dispositif d'échantillonnage (4) et un second dispositif d'échantillonnage (5), dans lequel les deux dispositifs d'échantillonnage (4, 5) sont réalisés de la même manière, en ce sens que le premier dispositif d'échantillonnage (4) comprend une unité de détection (42) destinée à échantillonner ladite piste de code (11) ainsi qu'une unité de détection (41) destinée à échantillonner la piste incrémentielle (13), et **en ce que** le second dispositif d'échantillonnage (5) comprend une unité de détection (52) destinée à échantillonner l'autre piste de code (12) ainsi qu'une unité de détection (51) destinée à échantillonner la piste incrémentielle (13).

FIG. 1

| A0 | A1 | A2 | A3 | A4 | A0 | A1 | A2 | A3 | A4 | A0 | A1 | A2 | A3 |
|----|----|----|----|----|----|----|----|----|----|----|----|----|----|

| B0 | B1 | B2 | B3 | B0 | B1 | B2 | B3 | B0 | B1 | B2 | B3 | B0 | B1 |
|----|----|----|----|----|----|----|----|----|----|----|----|----|----|

FIG. 2

## Fig. 3

Input:
Wörter WA aus Spur 11
Wörter WB aus Spur 12

$$x_A = T_A(W_A)$$
$$x_B = T_B(W_B)$$

if $(x_A \leq x_B)$ then
$\quad n = x_B - x_A$
else
$\quad n = (x_B - x_A + L_B)$

$$POS = n \cdot L_A + x_A$$

## Fig. 4

| WA | WB | XA | XB | n | POS |
|------|------|----|----|---|-----|
| 0111 | 0100 | 0 | 0 | 0 | 0 |
| 1111 | 1000 | 1 | 1 | 0 | 1 |
| 1110 | 0001 | 2 | 2 | 0 | 2 |
| 1101 | 0010 | 3 | 3 | 0 | 3 |
| 1011 | 0100 | 4 | 0 | 0 | 4 |
| 0111 | 1000 | 0 | 1 | 1 | 5 |
| 1111 | 0001 | 1 | 2 | 1 | 6 |
| 1110 | 0010 | 2 | 3 | 1 | 7 |
| 1101 | 0100 | 3 | 0 | 1 | 8 |
| 1011 | 1000 | 4 | 1 | 1 | 9 |
| 0111 | 0001 | 0 | 2 | 2 | 10 |
| 1111 | 0010 | 1 | 3 | 2 | 11 |
| 1110 | 0100 | 2 | 0 | 2 | 12 |
| 1101 | 1000 | 3 | 1 | 2 | 13 |
| 1011 | 0001 | 4 | 2 | 2 | 14 |
| 0111 | 0010 | 0 | 3 | 3 | 15 |
| 1111 | 0100 | 1 | 0 | 3 | 16 |
| 1110 | 1000 | 2 | 1 | 3 | 17 |
| 1101 | 0001 | 3 | 2 | 3 | 18 |
| 1011 | 0010 | 4 | 3 | 3 | 19 |

FIG. 5

## Fig. 6

Input:
Wörter WA, Wörter WB

$x_A = T_A(W_A)$
$x_B = T_B(W_B)$

$n = (x_B - x_A + i \cdot L_B)/(L_A - L_B)$

mit $n \geq 0$ und ganzzahlig für kleinstes ganzzahliges
$i \in [0, L_A - L_B]$

$POS = n \cdot L_A + x_A$

## Fig.7

| Wort WA | Wort WB | XA | XB | i | | | n | POS |
|---|---|---|---|---|---|---|---|---|
| | | | | 0 | 1 | 2 | | |
| 0111 | 0100 | 0 | 0 | 0 | 2 | 4 | 0 | 0 |
| 1111 | 1000 | 1 | 1 | 0 | 2 | 4 | 0 | 1 |
| 1110 | 0001 | 2 | 2 | 0 | 2 | 4 | 0 | 2 |
| 1100 | 0010 | 3 | 3 | 0 | 2 | 4 | 0 | 3 |
| 1001 | 0100 | 4 | 0 | -2 | 0 | 2 | 0 | 4 |
| 0111 | 1000 | 5 | 1 | -2 | 0 | 2 | 0 | 5 |
| 0111 | 0001 | 0 | 2 | 1 | 3 | 5 | 1 | 6 |
| 1111 | 0010 | 1 | 3 | 1 | 3 | 5 | 1 | 7 |
| 1110 | 0100 | 2 | 0 | -1 | 1 | 3 | 1 | 8 |
| 1100 | 1000 | 3 | 1 | -1 | 1 | 3 | 1 | 9 |
| 1001 | 0001 | 4 | 2 | -1 | 1 | 3 | 1 | 10 |
| 0111 | 0010 | 5 | 3 | -1 | 1 | 3 | 1 | 11 |

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2008056546 A1
- EP 0800725 B1